(19) **Europäisches Patentamt / European Patent Office / Office européen des brevets**

(11) **EP 1 906 530 A1**

(12) **EUROPEAN PATENT APPLICATION**
published in accordance with Art. 153(4) EPC

(43) Date of publication:
02.04.2008 Bulletin 2008/14

(51) Int Cl.:
$H03H\ 21/00\ ^{(2006.01)}$  $H03H\ 17/02\ ^{(2006.01)}$
$H03H\ 17/06\ ^{(2006.01)}$  $H04B\ 3/06\ ^{(2006.01)}$
$H04B\ 7/005\ ^{(2006.01)}$

(21) Application number: 06781174.5

(22) Date of filing: 18.07.2006

(86) International application number:
PCT/JP2006/314153

(87) International publication number:
WO 2007/010889 (25.01.2007 Gazette 2007/04)

(84) Designated Contracting States:
AT BE BG CH CY CZ DE DK EE ES FI FR GB GR
HU IE IS IT LI LT LU LV MC NL PL PT RO SE SI
SK TR

(30) Priority: 15.07.2005 JP 2005206722

(71) Applicant: NEC Corporation
Minato-ku
Tokyo 108-8001 (JP)

(72) Inventors:
• HOSHUYAMA, Osamu
c/o NEC Corporation
Tokyo 108-8001 (JP)
• SUGIYAMA, Akihiko
c/o NEC Corporation
Tokyo 108-8001 (JP)

(74) Representative: Vossius & Partner
Siebertstrasse 4
81675 München (DE)

(54) **ADAPTIVE DIGITAL FILTER, FM RECEIVER, SIGNAL PROCESSING METHOD, AND PROGRAM**

(57) The adaptive digital filter of the present invention includes: a filter unit that includes a plurality of multipliers ($336_0$-$336_{N-1}$) that are divided into groups of at least one multiplier and the other multipliers based on expected values of filter coefficients and that generates first signals by means of convolution operations of an input signal and filter coefficients; an adder (338) that adds the input signal that is applied to at least one multiplier ($336_{M-1}$) and first signals and supplies the results as second signals; and coefficient control unit (318 and $319_0$-$319_{N-1}$) that control filter coefficients based on error between a target signal and an index value derived from the second signals.

Fig. 3

## Description

### Technical Field

The present invention relates to an adaptive digital filter, and more particularly, to an adaptive digital filter, an FM receiver, a signal processing method, and a program that is executed on a computer, and that are suitable for a multipath equalizer of an FM (Frequency Modulation) receiver.

### Background Art

FM modulated waves used in FM radio broadcasting and television broadcasting are signals in which a sine wave carrier signal is subjected to phase modulation by a music signal. FM modulated waves have high resistance against noise and can transmit music signals having a wide band of 15 kHz with a low distortion factor. However, in multipath propagation paths, which include paths other than the path by which a radio waves arrive directly and in which radio waves are reflected by obstructions such as buildings and thus arrive with a delay, the phase information required for demodulation is disturbed by the influence of strong reflected waves that are received together with direct waves, and distortion therefore occurs in the demodulated signal. This distortion that is produced as a result of multipath propagation paths is referred to as "multipath distortion." An equalizer for reducing multipath distortion by compensating for the characteristics of multipath propagation paths is referred to as a "multipath equalizer" or a "multipath distortion canceller."

A multipath equalizer compensates for the effect of multipaths in a received signal by passing the received signal through a filter having the inverse characteristics of the multipath propagation paths, i.e., an inverse filter. The characteristics of the multipath propagation paths change according to the environment, and the characteristics of the inverse filter therefore must also be optimized according to the conditions over time. As a result, adaptive digital filters are typically used as inverse filters.

An adaptive digital filter is a filter having the capability for automatically updating the filter coefficient according to changes in the environment. An algorithm for calculating filter coefficients at each point in time is referred to as an "adaptive algorithm," an LMS (Least Mean Square) algorithm being a representative example. In a broad sense, an LMS algorithm is a method of minimizing the mean-square error based on a steepest-descent method and offers the advantages of stability and a small amount of operations. Adaptive algorithms known as "complex LMS algorithms" are also known. A complex LMS algorithm is an extension of the LMS algorithm in which each of the input signal, output signal, target signal, and filter coefficients are complex amounts, and is used, for example, by separating the in-phase component and quadrature component and realizing adaptation when the input is a narrow-band high-frequency signal.

On the other hand, a conventional equalizer that is realized using an adaptive digital filter requires a reference signal (training signal) for this adaptation, and this requirement tends to cause a reduction of communication efficiency due to interruptions in communication and redundant reference signals. In contrast, a recently developed equalizer known as the "blind equalizer" performs restorative equalization of signals based only on the received signals without requiring a reference signal for adaptation. An algorithm for application in this type of blind equalization is called a "blind algorithm," a CMA (Constant Modulus Algorithm) being a representative example. One example of a CMA is disclosed in C. Richard Johnson, Jr., Philip Schniter, Thomas J. Endres, James D. Behm, Donald R. Brown, and Raúl A. Casas, "Blind Equalization Using the Constant Modulus Criterion: A Review" (Proceedings of IEEE, Vol. 86, No. 10, October 1998) (hereinbelow referred to as "Non-Patent Document 1").

As shown in Non-Patent Document 1, CMA typically refers to an algorithm that takes as an index a statistic relating to the output signal such as the envelope of the filter output or a higher-order statistic and that updates filter coefficients such that this index approaches a target value. An example of using a constant-amplitude modulated wave in which the amplitude of the modulated wave is fixed, as in FM modulation, is disclosed in: J. R. Treichler and B. G. Agee, "A New Approach to Multipath Correction of Constant Modulus Signals" (IEEE Transactions on Acoustics, Speech, and Signal Processing, Vol. 31, No. 2, pp. 459-472, April 1983) (Hereinbelow referred to as "Non-Patent Document 2"). As shown in Non-Patent Document 2, when using a constant-amplitude modulated wave, the envelope of the filter output, i.e., the amplitude, is used as the index, and the filter coefficient is updated to minimize the error between a target value and the value of the envelope of the signal following passage through the filter. In this way, distortion of phase is corrected together with the distortion of the envelope, and the influence of the reflected waves of multipath propagation paths is eliminated. Here, CMA is a different concept than an adaptive algorithm. In CMA, an adaptive algorithm such as the previously mentioned LMS algorithm is used as an adaptive algorithm for calculating filter coefficients at each time point.

In order to control the value of the envelope of the output signal of a filter to a uniform value as described above, the value of the envelope must be extracted instantaneously, and complex signal processing is a representative method of this type of extraction. In complex signal processing, a real signal f2 having phase that is delayed 90° ($\pi/2$) with respect to a particular real signal f1 is generated by, for example, a Hilbert transformer, whereby a complex signal (typically referred to as an "analytic signal") having f1 as a real part and f2 as an imaginary part is generated. In this way, the value of the envelope of this real signal can be found instantaneously by calculating the square sum of the real part and imaginary part of the complex signal. However, when the output signal of the filter is subjected to complex signal processing, delay caused by the complex signal processing enters into the coefficient update loop and gives rise to instability of the loop. As a result, the complex signal processing is carried out upon the input signal. In this case, the input signal becomes a complex signal, and an algorithm that can handle complex quantities such as a complex LMS algorithm is therefore used as the adaptive algorithm. This method is referred to as the "first technique of the related art."

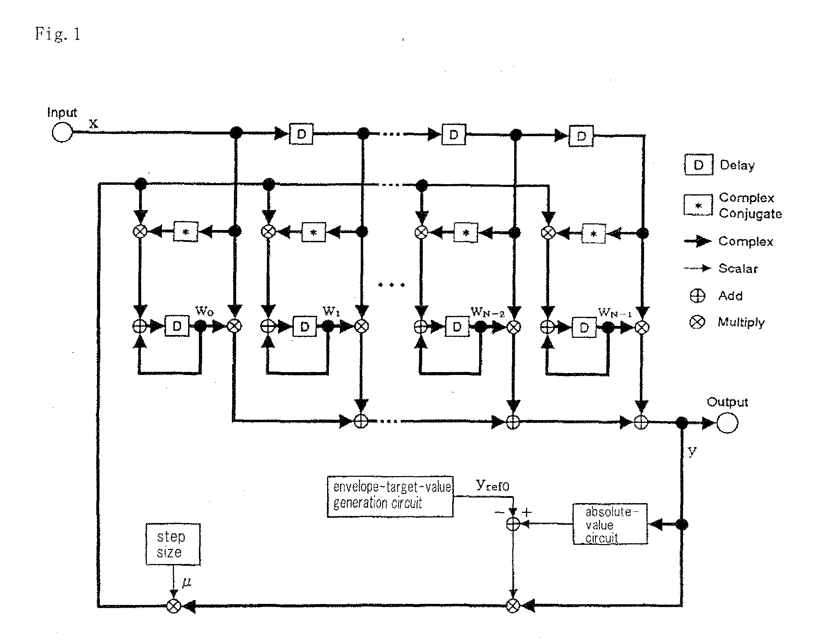

FIG. 1 shows the configuration of an adaptive digital filter that uses the first technique of the related art. Input signal X(k) is converted to a complex signal by a Hilbert transformer (not shown). Complex filter coefficient W(k) is convoluted with this complex signal as input to obtain output signal y(k), which is a complex signal. Complex filter coefficient W(k) is updated by an adaptive algorithm that has been expanded to handle complex signals such that the value of the envelope of output signal y(k) approaches a target value that has been prescribed in advance. The algorithm of this adaptive digital filter is represented as shown below:

$$W(k+1) = W(k) - \mu(|y(k)|^p - yref0)^q y(k)X^H(k) \qquad (1)$$

$$y(k) = W^T(k)X(k) \qquad (2)$$

$$W(k) = [w_0(k), w_1(k), \ldots, w_{N-1}(k)]^T \qquad (3)$$

$$X(k) = [x(k), x(k-1), \ldots, x(k-N+1)]^T \qquad (4)$$

where W(k) represents a filter coefficient vector, X(k) represents a complex signal vector, k represents a sample index, and N represents the number of filter taps. Further, y(k) represents the output signal, yref0 represents the envelope target value, and $\mu$ represents a parameter for determining the amount of updating of the filter coefficients. In addition, H represents a complex conjugate transposition, and T represents a transposition. The values p and q are constants for determining an evaluation function of error for the envelope target value, and for example, may be p=1 and q=1.

In the first technique of the related art, two signals having phases shifted 90° ($\pi/2$) with respect to each other are generated by applying complex signal processing. However, as can be seen from the document JP-A-2005-064618 (Hereinbelow referred to as "Patent Document 1") and Itami Makoto, Hatori Mitsutoshi, Tsukamoto Norio, "Hardware Implementation of FM Multipath Distortion Canceller" (National Convention Record of the Institute of Television Engineers of Japan, pp. 355-356, 1986) (hereinbelow referred to as "Non-Patent Document 3"), if sampling is carried out at a frequency of (4/odd number) times the carrier frequency when sampling the input signal, the phases of adjacent sample points will be shifted 90°. By taking this approach, an adaptive algorithm for handling real numbers can be used as is, whereby the square sum of adjacent sample points can be calculated when seeking the value of the envelope of the output signal. This method is referred to as the "second technique of the related art."

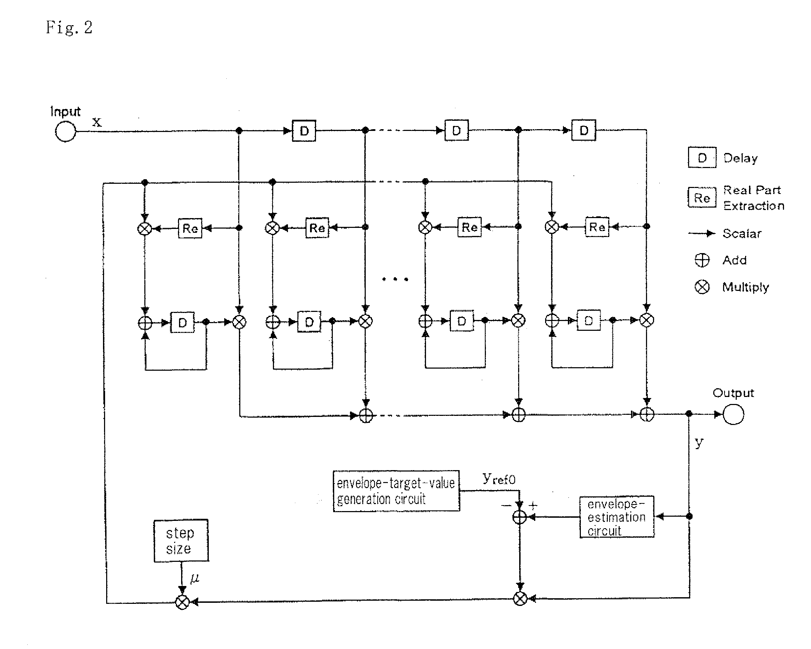

FIG. 2 shows the configuration of an adaptive digital filter that uses the second technique of the related art. Input signal Xr(k) is a real signal, and the real-signal filter coefficient Wr(k) is convoluted with this real signal as input to obtain real-signal output signal yr(k). Filter coefficient Wr(k) is updated by an adaptive algorithm that handles real coefficients such that the envelope of output signal yr(k) approaches a target value that has been prescribed in advance. This adaptive digital filter algorithm is represented as shown below:

$$Wr(k+1) = Wr(k) - \mu(Env[yr(k)] - yref0) \, yr(k) \, Xr(k) \qquad (5)$$

$$yr(k) = Wr^T(k) \, Xr(k) \qquad (6)$$

$$Env[yr(k)] = (yr^2(k-1) + yr^2(k))^{1/2} \qquad (7)$$

$$Wr(k) = Re[W(k)] \qquad (8)$$

$$Xr(k) = Re[X(k)] \qquad (9)$$

where $Wr(k)$ represents a real coefficient vector, $Xr(k)$ represents a real signal vector, $Env[\ ]$ represents an operation for obtaining an approximate value of an envelope, $Re[\ ]$ represents an operation for taking the real part of the complex number, and $yr(k)$ represents a real-number output signal.

**Disclosure of the Invention**

Drawbacks of a conventional adaptive digital filter include the large amount of operations and the necessity for large-scale hardware, the reasons for these requirements being as follows:

The first reason for these requirements is the large number of bits of filter coefficients. An adaptive digital filter requires both memory units (delay units) for saving the current value of each filter coefficient and multipliers that take each of the filter coefficients as multiplicands equal in number to the number of filter coefficients (the tap number), resulting in a large amount of hardware overall even when the number of bits for one filter coefficient is small. Operations for numbers having many bits result in further increases in the amount of operations.

The second reason for the need for a large amount of hardware is the complex signal processing. Essentially, nearly all signal processing for input signal $X(k)$, filter coefficient $W(k)$, and output signal $y(k)$ in the adaptive digital filter shown in FIG. 1 is carried out by complex numbers. A single multiplication between complex numbers corresponds to four real-number multiplications and two additions. In the multipath equalizer for an FM receiver, the convolution operations and coefficient updating operations of a filter having many taps must be executed for each short sampling cycle, and the amount of operations is therefore voluminous.

In the adaptive digital filter shown in FIG. 2, a sampling frequency that is an exact multiple of (4/odd number) as seen from the center frequency of an intermediate-frequency signal not only enables high accuracy in of the calculation of the envelope and the achievement of performance equivalent to that of the adaptive digital filter of FIG. 1, but also enables a reduction of the amount of operations to approximately 25%. However, this approach raises the different problems of severe limitations on the sampling frequency and the inability to design at any sampling frequency. If the sampling frequency diverges from a multiple of (4/odd number) of the center frequency of an intermediate-frequency signal, the accuracy of calculating the envelope drops, resulting in degradation of the multipath-equalizing performance.

The present invention was proposed in view of these circumstances and therefore has as its object the provision of an adaptive digital filter, an FM receiver, a signal processing method, and a program that can be executed on a computer that are capable of reducing the amount of operations and the amount of hardware.

The adaptive digital filter of the present invention for achieving the above-described object is of a configuration that includes: a filter unit that includes a plurality of multipliers divided into groups of at least one multiplier and other multipliers based on expected values of filter coefficients, for generating first signals by means of convolution operations of an input signal and filter coefficients; an adder for adding the input signal that is applied as input to at least one multiplier and the first signals to supply second signals as output; and a coefficient control unit for controlling the filter coefficients based on error between a target signal and an index value derived from the second signals.

According to the present invention, the division into groups causes a difference in filter coefficients between at least one multiplier and the other multipliers. The input signal applied as input to this one multiplier, if left unchanged, is equivalent to the value obtained by multiplying at the multiplier of filter coefficient 1, and implementing control to extract this input signal to add to the first signal that is the output of the filter unit to generate a second signal and implementing control to decrease the filter coefficient of the above-described multiplier based on error between a target signal and an index value such that the amount of the above-described input signal is not included in the multiplication result in the above-described multiplier suppresses variation of filter coefficients in the filter unit to a smaller value than in the related art. As a result, the number of bits required for multipliers for the convolution operations and delay units for holding filter coefficients can be reduced, the amount of operations can be decreased, and the amount of hardware can be cut.

In addition, the adaptive digital filter of the present invention is of a configuration that includes: a filter unit that includes a plurality of multipliers for carrying out convolution operations of an input signal and filter coefficients and that enlarges by a prescribed magnification the output of at least one multiplier of the plurality of multipliers and generating the results of the convolution operations as first signals; and a coefficient control unit for controlling the filter coefficients used in the plurality of multipliers based on error between a target signal and an index value derived from the first signals and for reducing, by the prescribed magnification, a signal that depends on error that is the basis for generation of filter coefficients that are used in the multipliers in which output is enlarged at a prescribed magnification.

According to the present invention, the output signal of at least one multiplier among multipliers for the convolution operations is enlarged, and the signal that accords with the error that serves as the basis for generation of filter coefficients used in the multipliers is reduced by a proportion that matches that of the enlargement, whereby the filter coefficients required by multipliers for the convolution operations can be values that are substantially smaller than in the related art. As a result, the number of bits required for multipliers for the convolution operations and delay units for holding filter coefficients can be decreased, the amount of operations can be reduced, and the amount of hardware can be cut.

Still further, the FM receiver of the present invention for achieving the above-described object is of a configuration that includes: an adaptive digital filter according to the present invention as described above; and a Hilbert transformer for applying as input to the adaptive digital filter a complex signal generated by subjecting an FM modulated signal that has been converted to an intermediate frequency and digitized to a Hilbert transformation.

As described in the foregoing explanation, the amount of signal processing operations for realizing an adaptive digital filter can be reduced in the present invention. This reduction can be achieved because the filter coefficients used in the multipliers for the convolution operations can be values that are substantially smaller than in the related art.

**Brief Description of the Drawings**

FIG. 1 is a block diagram of an adaptive digital filter according to the first technique of the related art;
FIG. 2 is a block diagram of an adaptive digital filter according to the second technique of the related art;
FIG. 3 is a block diagram of an adaptive digital filter according to the first exemplary embodiment of the present invention;
FIG. 4 is a flow chart for explaining the operations of the adaptive digital filter according to the first exemplary embodiment of the present invention;
FIG. 5 is a diagram showing the simulation results at the time of convergence of filter coefficients of an adaptive digital filter;
FIG. 6 is a block diagram of the adaptive digital filter according to the second exemplary embodiment of the present invention;
FIG. 7 is a block diagram of the adaptive digital filter according to the third exemplary embodiment of the present invention;
FIG. 8 is a block diagram of the adaptive digital filter according to the fourth exemplary embodiment of the present invention;
FIG. 9 is a block diagram of the adaptive digital filter according to the fifth exemplary embodiment of the present invention;
FIG. 10 is a block diagram of the adaptive digital filter according to the sixth exemplary embodiment of the present invention;
FIG. 11 is a block diagram of the adaptive digital filter according to the seventh exemplary embodiment of the present invention;
FIG. 12 is a block diagram of a working example of a group processor used in the adaptive digital filter according to the seventh exemplary embodiment of the present invention;
FIG. 13 is a block diagram of a working example of an individual processor used in the adaptive digital filter according to the seventh exemplary embodiment of the present invention; and
FIG. 14 is a block diagram of an FM receiver according to an exemplary embodiment of the present invention.

Explanation of Reference Numbers

**[0021]**

| | |
|---|---|
| 105 | Hilbert transformer |
| 303 | step-size generation circuit |

| 305 | envelope-target-value generation circuit |
|---|---|
| 307 | subtractor |
| 308 | absolute-value circuit |
| 309 | real-part extraction circuit |
| 310, 331 | multipliers |
| 318 | common unit |
| $319_0$-$319_{N-1}$ | separate units |
| $330_1$-$330_{N-1}$ | delay units |
| $331_0$-$331_{N-1}$ | multipliers |
| $341_0$-$341_{N-1}$ | multipliers |
| $333_0$-$333_{N-1}$ | adders |
| $343_0$-$343_{N-1}$ | adders |
| $334_0$-$334_{N-1}$ | delay units |
| $344_0$-$344_{N-1}$ | delay units |
| $335_0$-$335_{N-1}$ | real-part extraction circuits |
| $336_0$-$336_{N-1}$ | multipliers |
| $337_1$-$337_{N-1}$ | adders |
| 338 | adder |
| 349 | branch line |
| $339_1$-$339_{N-1}$ | delay units |
| $340_0$-$340_{N-1}$ | complex conjugate unit |

**Best Mode for Carrying Out the Invention**

First Exemplary Embodiment

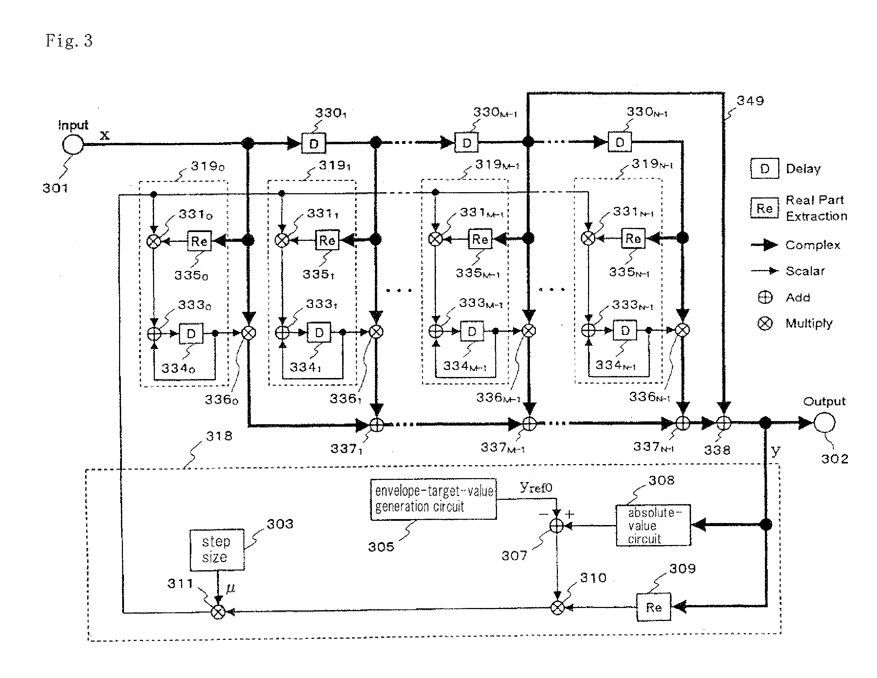

Explanation next regards the configuration of an adaptive digital filter of an exemplary embodiment of the present invention. FIG. 3 is a block diagram showing an example of the configuration of an adaptive digital filter according to the present exemplary embodiment.

Referring to FIG. 3, the adaptive digital filter according to the exemplary embodiment of the present invention is provided with: a filter unit for generating an output signal that is a complex signal (complex output signal) by means of convolution operations of a complex signal (complex input signal) received as input by way of input terminal 301 and filter coefficients (real filter coefficients) that are real signals and for supplying the output to output terminal 302; and a coefficient control unit for controlling filter coefficients based on the error between a target signal and an index value derived from the complex output signal (in the present exemplary embodiment, the value of the envelope). In FIG. 3, the portion of common unit 318 that is indicated by a broken-line box and N (where N is an integer equal to or greater than 2) separate units $319_0$-$319_{N-1}$ that are indicated in broken-line boxes make up the coefficient control unit, and the remaining portions make up the filter unit. In this case, the complex input signal is a complex signal in which one of two signals generated from a single real signal and having phases shifted 90° from each other is a real part and the other signal is an imaginary part.

The filter unit is provided with: an FIR (Finite Impulse Response) filter for which the tap number, i.e., the number of filter coefficients, is N and that includes a tapped delay line composed of N-1 delay units $330_1$-$330_{N-1}$ that each give a delay of one sampling cycle, N multipliers $336_0$-$336_{N-1}$ for multiplying the complex input signal and the output signal of each of delay units $330_1$-$330_{N-1}$ by a filter coefficient, and N-1 adders $337_1$-$337_{N-1}$ for successively adding the multiplication results of these N multipliers $336_0$-$336_{N-1}$; branch line 349 for extracting the output signal of delay unit $330_{M-1}$; and adder 338 for adding the output signal of the FIR filter, i.e., the output signal of adder $337_{N-1}$, and the signal extracted at branch line 349 and transmitting this result to output terminal 302.

A configuration that includes delay unit $330_S$ (where S is any positive integer of at least 1 but no greater than (N-1)), multiplier $336_S$, and adder $337_S$ is a basic element of a filter and is referred to as a "tap." In addition, the tap that includes delay unit $330_{M-1}$, multiplier $336_{M-1}$, and adder $337_{M-1}$ is referred to as the "center tap." Here, M is a positive integer equal to or greater than 1.

The case next described is one example of a method of determining the initial value of each filter coefficient. In the case of multipath propagation, the filter coefficients of the filter unit are all set to the same value before activation of the adaptive digital filter, and each filter coefficient changes when the adaptive digital filter is activated. After convergence, the expected values of the filter coefficients in each tap are found. The initial value of each filter coefficient is then set in accordance with the expected values that have been found. In particular, when not a case of multipath propagation, i.e., when there are only directly propagated waves, the expected values of filter coefficients are obtained without bringing about convergence, the taps are classified as one tap in which the expected value of the filter coefficient is "1" and the other taps in which the expected values are "0," and these expected values then set as the initial values.

In the present exemplary embodiment, the initial value of the filter coefficient of the center tap is set to a higher value than the other taps.

Taps can be classified into a plurality of groups depending on whether the filter coefficient is at least a reference value or less than the reference value based on the expected values of filter coefficients. According to the method of classification, the filter coefficient of the center tap is greater than that of the other taps, and the taps are thus grouped into the center tap and the other taps. The reference value may be set to, for example, "1.0."

The signal extracted by branch line 349 is a signal obtained by subjecting the input signal of input terminal 301 to (M-1) sampling delays, and this signal is the signal supplied as output from delay unit $330_{M-1}$ of the center tap. In other words, this signal corresponds to the output signal of the delay unit of the tap for which the initial value of the filter coefficient is greater than in other taps. Accordingly, the signal of the center tap is directly extracted and separately added in adder 338 in the present exemplary embodiment.

In addition, the coefficient control unit is of a configuration that uses LMS as an adaptive algorithm and that includes common unit 318 that is common to the control of all filter coefficients and separate units $319_0$-$319_{N-1}$ for the separate control of each individual filter coefficient.

Common unit 318 is of a configuration that includes: absolute-value circuit 308 for, upon the input of the complex output signal that is the output of the filter unit, calculating the value of the envelope of the complex output signal by the square sum of the real part and imaginary part to supply as output; envelope-target-value generation circuit 305 for generating the value with which the envelope is to converge, i.e., the envelope target value; subtractor 307 for supplying as output a value obtained by subtracting the envelope target value from the value of the envelope that was found in absolute-value circuit 308; real-part extraction circuit 309 for, upon input of the complex output signal, extracting only the real part of this signal to supply as output; multiplier 310 for supplying as output the result of multiplying the output of subtractor 307 and the output of real-part extraction circuit 309; step-size generation circuit 303 for generating a step size that is a parameter for determining the update amount of a filter coefficient; and multiplier 311 for supplying as output to each of separate units $319_0$-$319_{N-1}$ the result of multiplying the output of multiplier 310 and the step size.

In the case of the present exemplary embodiment, the filter coefficients are real numbers and not complex numbers, and the step size generated at step-size generation circuit 303 is therefore set to approximately four times the step size when using complex filter coefficients, whereby the speed of convergence can be made equivalent to a case of using complex filter coefficients.

Separate units $319_0$-$319_{N-1}$ are each of a configuration that includes: real-part extraction circuits $335_0$-$335_{N-1}$ for, upon input of the complex input signal or the output signal of corresponding delay units $330_1$-$331_{N-1}$ on the tapped delay line, extracting only the real part of the complex signal and supplying this real part as output; multipliers $331_0$-$331_{N-1}$ for supplying as output the results of multiplying a signal received as input from common unit 318 and the real parts extracted at real-part extraction circuits $335_0$-$335_{N-1}$; adders $333_0$-$333_{N-1}$ for adding the filter coefficients that have been given to multipliers $336_0$-$336_{N-1}$ and the outputs of multipliers $331_0$-$331_{N-1}$ and supplying as output the filter coefficients that are to be used in the next sampling cycle; and delay units $334_0$-$334_{N-1}$ for delaying the outputs of these adders $333_0$-$333_{N-1}$ by exactly one sampling cycle and supplying as output to multipliers $336_0$-$336_{N-1}$.

The algorithm of the adaptive digital filter of the present exemplary embodiment is represented as shown below:

$$Wr(k+1) = Wr(k) - \mu(|y(k)|^p - yref0)^q \, Re[y(k)] \, Re[X(k)] \qquad (10)$$

$$y(k) = Wr^T(k) \, X(k) + X(M-1) \qquad (11)$$

where Wr(k) represents a real coefficient vector, X(k) represents a complex signal vector, and Re[ ] represents the operation of extracting the real part of a complex number. In addition, y(k) is the complex output signal, k represents the sampling index, N represents the number of filter taps, yref0 is the envelope target value, $\mu$ is a parameter for determining the update amount of a filter coefficient, and X(M-1) is a signal extracted by branch line 349. The values p and q are constants for determining the evaluation function of the error for the envelope target value, and may be set to, for example, p=1 and q=1.

Explanation next regards the operation of the adaptive digital filter of the present exemplary embodiment.

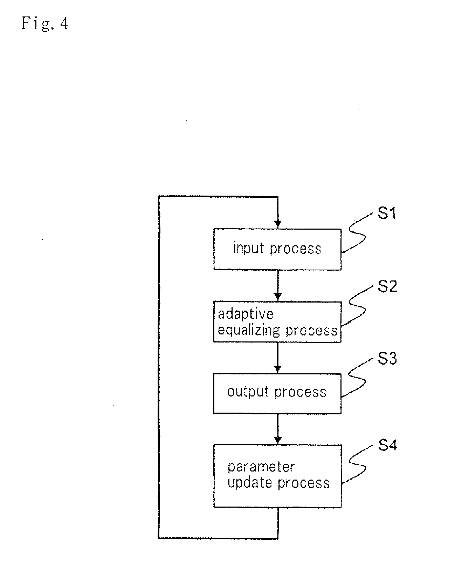

FIG. 4 is a flow chart showing the operation of the adaptive digital filter of the present exemplary embodiment. Upon input of a new complex input signal by way of input terminal 301 (input process S1), the adaptive digital filter subjects the complex input signal to an adaptive equalizing process (adaptive equalizing process S2) and then supplies the complex output signal obtained by adaptive equalizing process S2 to output terminal 302 (output process S3). A process for updating parameters (parameter update process S4) is next carried out. The above-described processes from input process 1 to parameter update process S4 are repeated with each input of a new complex input signal by way of input terminal 301. Adaptive equalizing process S2 is a process based on Equation (11) shown above, and parameter update process S4 is a process based on Equation (10) shown above. The following explanation regards details of the operation of adaptive equalizing process S2 and parameter update process S4.

First, regarding adaptive equalizing process S2, the complex input signal that is received as input at input terminal 301 is supplied to multiplier $336_0$ and real-part extraction circuit $335_0$, and at the same time, supplied to the tapped delay line that is composed of delay units $330_1$-$330_{N-1}$ that generate delays of one sampling cycle. The complex signal supplied to delay units $330_1$-$330_{N-1}$ is transmitted to an adjacent delay unit with each clock, and the output signals of each of delay units $330_1$-$330_{N-1}$ are supplied to corresponding multipliers $336_1$-$336_{N-1}$ and corresponding real-part extraction circuits $335_1$-$335_{N-1}$. In addition, the output signal of delay unit $330_{M-1}$ is extracted by branch line 349 and supplied to adder 338.

In multiplier $336_0$, the real-number filter coefficient supplied from delay unit $334_0$ is multiplied by the complex signal received as input from input terminal 301 and the result is supplied to adder $337_1$. In multipliers $336_1$-$336_{N-1}$, the real-number filter coefficients supplied from corresponding delay units $334_1$-$334_{N-1}$ are multiplied by the complex signals supplied from delay unit $330_1$-$330_{N-1}$ and the results are supplied to adders $337_1$-$337_{N-1}$. Adders $337_1$-$337_{N-1}$ add all complex signals received from multipliers $336_0$-$336_{N-1}$ and supply the result to adder 338.

In adder 338, the signal supplied from adder $337_{N-1}$ and the signal extracted by branch line 349 are added, the result is supplied to output terminal 302, and at the same time, supplied to absolute-value circuit 308 and real-part extraction circuit 309. In this way, a complex signal is generated and supplied that is obtained by adding the complex signal extracted from the center tap and the complex signal that is generated by the convolution operation of the complex input signal and a filter coefficient that is a real signal.

Next, regarding parameter update process S4, absolute-value circuit 308 receives the complex output signal, calculates the absolute value of this signal and transmits this result as the value of the envelope to subtractor 307. Envelope-target-value generation circuit 305 generates an envelope target value and transmits this value to subtractor 307. Subtractor 307 subtracts the envelope target value received from envelope-target-value generation circuit 305 from the signal received from absolute-value circuit 308 and transmits the result to multiplier 310. Real-part extraction circuit 309 receives the complex output signal, extracts only the real part from this signal, and transmits this result to multiplier 310. Multiplier 310 multiplies the signal received from real-part extraction circuit 309 by the signal received from subtractor 307 and transmits the result to multiplier 311. Step-size generation circuit 303 generates a step size, which is a parameter for determining the amount of updating of filter coefficients in the filter unit and supplies the step size to multiplier 311. Multiplier 311 multiplies the step size supplied from step-size generation circuit 303 by the signal received from multiplier 310 and supplies the result to each of separate units $319_0$-$319_{N-1}$.

In each of separate units $319_0$-$319_{N-1}$, the signal supplied from multiplier 311 is transmitted to multipliers $331_0$-$331_{N-1}$. Real-part extraction circuits $335_0$-$335_{N-1}$ each extract the real part of the complex signal supplied from input terminal 301 or corresponding delay units $330_1$-$330_{N-1}$ and transmit the extracted real part to corresponding multipliers $331_0$-$331_{N-1}$. Multipliers $331_0$-$331_{N-1}$ multiply the real-number signal supplied from common unit 318 by the real-number signal supplied from corresponding real-part extraction units $335_0$-$335_{N-1}$, respectively, and transmit the results to corresponding adders $333_0$-$333_{N-1}$. Adders $333_0$-$333_{N-1}$ add the real-number filter coefficients supplied from corresponding delay units $334_0$-$334_{N-1}$ to the real-number signals received from corresponding multipliers $331_0$-$331_{N-1}$, respectively, and transmit the results as the filter coefficients to be used in the next sample to corresponding delay units $334_0$-$334_{N-1}$. Delay units $334_0$-$334_{N-1}$ delay the real-number filter coefficients received from corresponding adders $333_0$-$333_{N-1}$ by one sample and both supply the results to corresponding multipliers $336_0$-$336_{N-1}$ and transmit the results to corresponding adders $333_0$-$333_{N-1}$, respectively.

Explanation next regards the effects of the present exemplary embodiment.
Assuming the multipath propagation path H(z) as:

$$H(z) = 1 + a \cdot z^{-10} \qquad (12)$$

where a = 0.675, a simulation is now considered in which multipath distortion is eliminated using $G0(z) = Z^{-25}$ as the initial value of equalizing filter G(z). In this multipath propagation path, reflected waves arrive with a 10-sample delay compared to direct waves, and filter G(z) for equalizing H(z) therefore is ideally as follows:

$$G(z) = z^{-25} \cdot [1/H(z)]$$
$$= z^{-25} \cdot [1/(1 + a \cdot z^{-10})]$$
$$= z^{-25} \cdot [1 - a \cdot z^{-10} + a^2 \cdot z^{-20} - a^3 \cdot z^{-30} + a^4 \cdot z^{-40} - \ldots] \qquad (13)$$

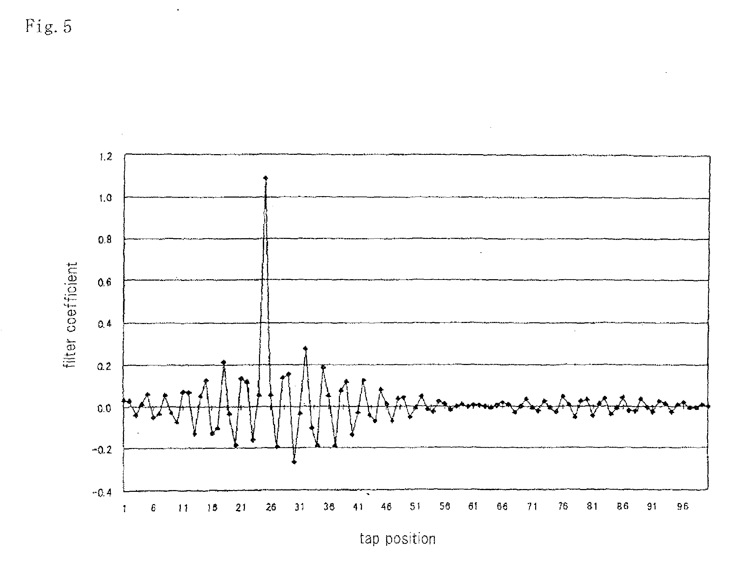

In other words, a filter coefficient that is not 0 appears with each tenth filter coefficient, with the 25th filter coefficient (tap coefficient) being "1," the 35th filter coefficient being "-a," the 45th filter coefficient being "+a2," and so on, and all other filter coefficients being "0." In actuality, however, the ideal pattern is not realized, and simulation results such as shown in FIG. 5 are obtained. In FIG. 5, the horizontal axis shows the tap position, and the vertical axis shows the filter coefficient.

Referring to FIG. 5, only the coefficient of the 25th tap that corresponds to the center tap is greater than "1" and all other tap coefficients are 0.5 or less. Although the regularity is not seen in which filter coefficients that are not "0" appear with every tenth coefficient and all other filter coefficients are "0," sufficient equalization has been realized in this state. This is because, in the time interval of ten taps, the input signal can be considered to be almost a sine wave of a fixed frequency, and a sine wave of a fixed frequency can be synthesized by adding a plurality of sine waves of the same frequency but with different phases. For example, if the filter coefficient of the 35th region is larger, a signal is obtained that is virtually the same as a case in which the 35th filter coefficient has increased to "-a."

Here, in a configuration in which branch line 349 and adder 338 are removed from the configuration of FIG. 3, if the signal of the center tap is X(M-1) and the filter coefficient of the center tap is $1+\Delta h$ (where $\Delta h < 0.5$), the output value of adder $336_{M-1}$ is:

$$X(M-1) \cdot (1 + \Delta h) = X(M-1) + X(M-1) \cdot \Delta h \qquad (14)$$

On the other hand, if $\Delta h$ is a value obtained by subtracting "1" from the filter coefficient saved in delay unit $334_{M-1}$ of the center tap in the configuration of FIG. 3, the output of adder $336_{M-1}$ is $X(M-1) \cdot \Delta h$. However, the signal transmitted by branch line 349 to adder 338 is X(M-1), and is therefore the same value as Equation (14) when totaled. In other words, in the present exemplary embodiment, an equivalent operation is carried out even when the filter coefficient given to multiplier $336_{M-1}$ of the center tap is $\Delta h$. As can be seen in the simulation results of FIG. 5, the values of all filter coefficients other than the center tap are no greater than 0.5, and the present exemplary embodiment therefore only stipulates that values no greater than 0.5 be handled as all filter coefficients. Accordingly, delay units $334_0$-$334_{N-1}$, adders $333_0$-$333_{N-1}$, and multipliers $336_0$-$336_{N-1}$ should handle values no greater than 0.5 as filter coefficients. As a result, the amount of operations and hardware can be reduced compared to an adaptive digital filter of the related art that handled values greater than 0.5 for all filter coefficients.

In the adaptive digital filter of the present exemplary embodiment, if multipliers $336_0$-$336_{N-1}$ are grouped based on filter coefficients, multiplier $336_{M-1}$ can be said to have a filter coefficient that differs from other multipliers. The input signal that is applied as input to this multiplier $336_{M-1}$, if unchanged, is equivalent to a value obtained by multiplying filter coefficient 1 by a multiplier, and if this input signal is extracted by the branch line and added to the output signal of the filter unit to generate a complex output signal, and further, if control is implemented to decrease the filter coefficient of multiplier $336_{M-1}$ based on the error between the index value and the target signal such that the above-described input signal portion is not included in the multiplication result in multiplier $336_{M-1}$, the variation of filter coefficients within the filter unit can be suppressed to a smaller value than in the related art.

In the present exemplary embodiment, the filter coefficient of multiplier $336_{M-1}$ is larger than in other multipliers. The input signal applied as input to multiplier $336_{M-1}$, if unchanged, is equivalent to a value obtained by multiplying filter coefficient 1 in a multiplier, and this input signal is extracted by branch line 349 and added to the output signal of the filter unit in adder 338 to generate a complex output signal. Control is then implemented to decrease the filter coefficient of multiplier $336_{M-1}$ based on the error between the index value and target signal such that the above-described input signal portion is not included in the multiplication results in multiplier $336_{M-1}$. As a result, the filter coefficient of multiplier $336_{M-1}$ is a substantially smaller value than the initial value. Accordingly, the number of bits required for multipliers for convolution operations and delay units for holding filter coefficients can be reduced, and the amount of operations and hardware can be decreased.

Further, as can be seen by referring to FIG. 3, most signals in the adaptive digital filter of the present exemplary embodiment are real numbers and not complex numbers. Because the signals are real numbers and not complex numbers, the amount of operations is decreased when compared to the first technique of the related art shown in FIG.

1. This decrease is realized because all signals are complex numbers in an adaptive digital filter according to the first technique of the related art and multiplication is therefore carried out between complex numbers in all multipliers, while in the present exemplary embodiment, multiplication is carried out between complex numbers and real numbers in multipliers $336_0$-$336_{N-1}$ and multiplication is carried out between real numbers in multipliers $331_0$-$33l_{N-1}$-Multiplication between complex numbers is equivalent to four multiplications between real numbers and two additions between real numbers, but multiplication between a complex number and a real number is equivalent to just two multiplications between real numbers, while multiplication between real numbers is equivalent to just one multiplication between real numbers.

Accordingly, replacing points at which multiplication is carried out between complex numbers in the first technique of the related art with multipliers $336_0$-$336_{N-1}$ that carry out multiplication between complex numbers and real numbers realizes a decrease equivalent to N multiplications between real numbers. Replacing points at which multiplication is carried out between complex numbers in the first technique of the related art with multipliers $331_0$-$331_{N-1}$ that carry out multiplication between real numbers further realizes a decrease equivalent to 3N multiplications between real numbers and 2N additions of real numbers. Still further, the portion of real-part extraction circuits $335_0$-$335_{N-1}$ required a complex conjugation unit in the first technique of the related art, and the amount of operations is reduced to the degree that code of imaginary parts is not transmitted.

As described in the foregoing explanation, the amount of operations in the present exemplary embodiment can be cut to approximately 40% of the first technique of the related art.

Still further, the output signal of the filter unit is obtained as a complex number in the present exemplary embodiment, and as a result, the value of the envelope of the output signal, i.e., the amplitude, is obtained both instantaneously and accurately as the output signal of absolute-value circuit 308 of FIG. 3. Accordingly, the present exemplary embodiment places no restrictions on sampling frequency as in the second technique of the related art.

Second Exemplary Embodiment

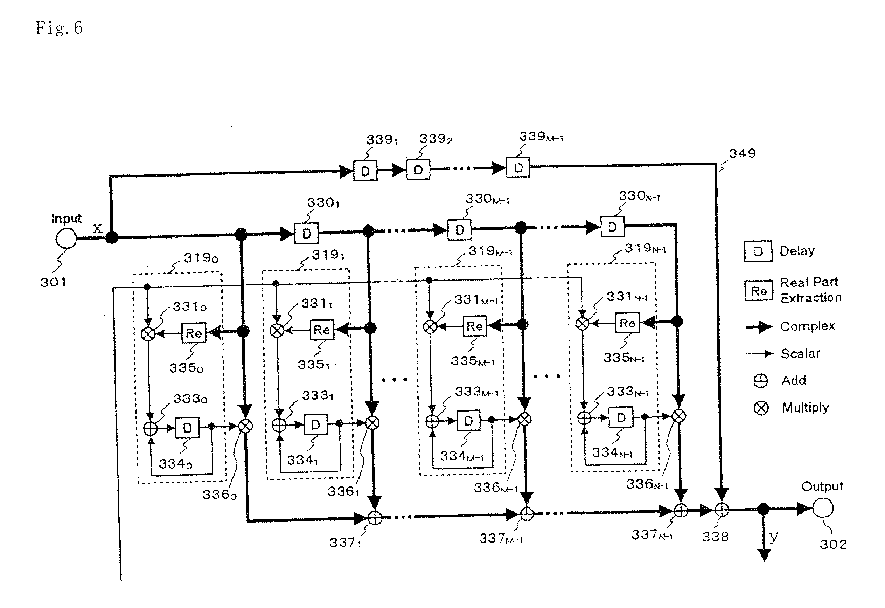

Explanation next regards the adaptive digital filter according to the second exemplary embodiment of the present invention using the block diagram of FIG. 6. Common unit 318 of the coefficient control unit shown in FIG. 3 has been omitted from the figure.

Referring to FIG. 6, the adaptive digital filter according to the second exemplary embodiment of the present invention differs from the adaptive digital filter according to the first exemplary embodiment of FIG. 3 in that the input signal that is received as input by way of input terminal 301 is transmitted through M-1 delay units $339_1$-$339_{M-1}$ and branch line 349 to effect a delay of (M-1) samples.

In the present exemplary embodiment, M-1 delay units $339_1$-$339_{M-1}$ are newly required, but the signal transmitted by branch line 349 to adder 338 is the same as in the first exemplary embodiment and the same effect can therefore be obtained as in the first exemplary embodiment.

Third Exemplary Embodiment

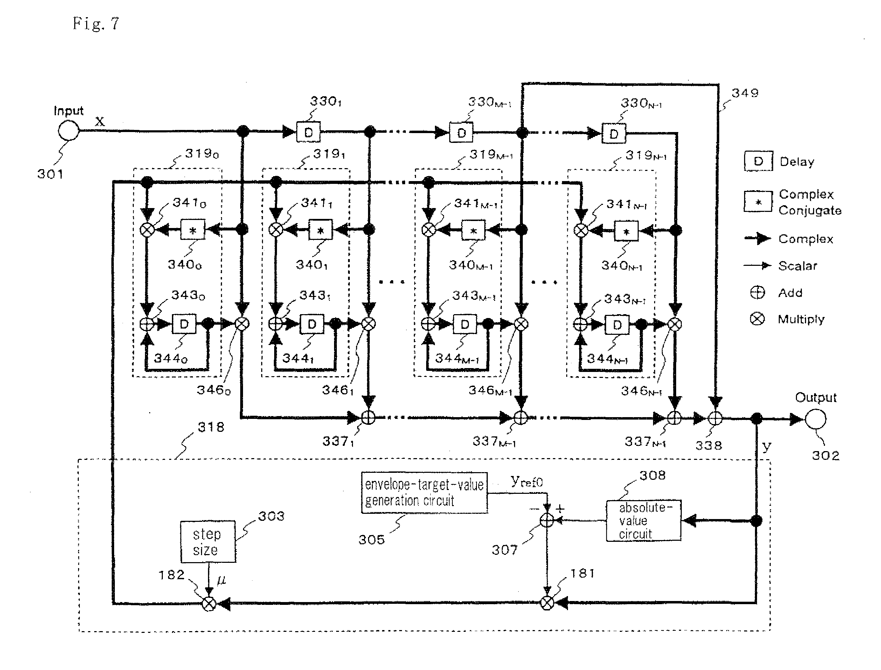

Explanation next regards the adaptive digital filter according to the third exemplary embodiment of the present invention using the block diagram of FIG.7.

Referring to FIG. 7, the adaptive digital filter according to the third exemplary embodiment of the present invention is provided with: a filter unit for generating an output signal that is a complex signal (complex output signal) by means of convolution operations of a complex signal (complex input signal) received as input by way of input terminal 301 and filter coefficients that are complex signals (complex filter coefficients) to supply the complex output signal to output terminal 302; and a coefficient control unit for controlling filter coefficients based on the error between a target signal and an index value derived from the complex output signal (in the present exemplary embodiment, the value of the envelope). In FIG. 7, the portion of common unit 318 indicated by a broken-line block and the N separate units $319_0$-$319_{N-1}$ indicated by the broken-line blocks make up the coefficient control unit, and the remaining portions make up the filter unit. Here, the complex input signal is a complex signal in which one of two signals generated from a single real signal and having phases shifted 90° with respect to each other is a real part and the other signal is an imaginary part.

The filter unit is provided with: an FIR filter in which the number of taps, i.e., the number of filter coefficients, is N and that includes a tapped delay line composed of N-1 delay units $330_1$-$330_{N-1}$ that each give delay of one sampling cycle, N multipliers $346_0$-$346_{N-1}$ for multiplying filter coefficients by each of the complex input signal and the output signals of each of delay units $330_1$-$330_{N-1}$, and N-1 adders $337_1$-$337_{N-1}$ for successively adding the multiplication results of these N multipliers $346_0$-$346_{N-1}$; branch line 349 for extracting the output signal of delay unit $330_{M-1}$; and adder 338 for adding the output signal of the FIR filter, i.e., the output signal of adder $337_{N-1}$ and the signal extracted by branch line 349 and transmitting the result to output terminal 302.

Here, the signal extracted by branch line 349 is a signal in which the input signal of input terminal 301 is delayed by (M-1) samples, this signal being the signal supplied from delay unit $330_{M-1}$ that is the center tap. In other words, this signal corresponds to the output signal of the delay unit in the tap in which the initial value of the filter coefficient is larger than that of other taps. Thus, in the present exemplary embodiment, the signal of the center tap is directly extracted and separately added at adder 338.

The coefficient control unit uses a complex LMS that is extended to handle complex numbers as its adaptive algorithm, and is of a configuration that includes common unit 318 that is common to control of all filter coefficient and separate units $319_0$-$319_{N-1}$ for the control of each individual filter coefficient.

Common unit 318 is of a configuration that includes: envelope-target-value generation circuit 305 for generating an envelope target value; absolute-value circuit 308 for, upon input of a complex output signal that is the output of the filter unit, calculating the value of the envelope of the complex output signal by means of the square sum of the real part and the imaginary part; subtractor 307 for supplying as output a value obtained by subtracting the envelope target value from the value of the envelope found in absolute-value circuit 308; multiplier 181 for supplying as output the result of multiplying the output of subtractor 307 and the complex output signal; step-size generation circuit 303 for generating a step size, which is a parameter for determining the amount of update of filter coefficients; and multiplier 182 for supplying as output to each of separate units $319_0$-$319_{N-1}$ the result of multiplying the output of multiplier 181 and the step size.

Separate units $319_0$-$319_{N-1}$ are each of a configuration that includes: complex conjugate units $340_0$-$340_{N-1}$ for, upon input of the complex input signal or the output signal of corresponding delay units $330_1$-$330_{N-1}$ on a tapped delay line, subjecting the complex signal to a complex conjugate conversion and supplying the result as output; multipliers $341_0$-$341_{N-1}$ for supplying the result of multiplication of the signal received as input from common unit 318 and the complex signal supplied from complex conjugation units $340_0$-$340_{N-1}$; adders $343_0$-$343_{N-1}$ for adding the filter coefficients given to multipliers $346_0$-$346_{N-1}$ and the outputs of multipliers $341_0$-$341_{N-1}$ and supplying the results as the filter coefficients to be used in the next sampling cycle; and delay units $344_0$-$344_{N-1}$ for delaying the outputs of these adders $343_0$-$343_{N-1}$ by exactly one sampling cycle and supplying the result to multipliers $346_0$-$346_{N-1}$.

The algorithm of the adaptive digital filter of the present exemplary embodiment is represented as follows:

$$W(k+1) = W(k) - \mu(|y(k)|^P - yref(k))^q \, y(k) \, X^H(k) \qquad (15)$$

$$y(k) = W^T(k) \, X(k) + X(M-1) \qquad (16)$$

$$W(k) = [w_0(k), w_1(k), \ldots, w_{N-1}(k)]^T \qquad (17)$$

$$X(k) = [x(k), x(k-1), \ldots, x(k-N+1)]^T \qquad (18)$$

$$yref(k) = Av[|x(k)|] \qquad (19)$$

$$Av[|x(k)|] = (1-\beta) \, Av[|x(k-1)|] + \beta|x(k)| \qquad (20)$$

where W(k) represents a filter coefficient vector, X(k) represents a complex signal vector, k represents a sampling index, and N represents the filter tap number. In addition, y(k) is an output signal, yref is the time-variant envelope target value, $\mu$ is a parameter for determining the amount of update of a filter coefficient, X(M-1) is a signal extracted by branch line 349, Av[] represents the operation of averaging, and $\beta$ is a weighting coefficient that is a positive constant satisfying the relation $0 < \beta < 1$. In addition, H represents a complex conjugate transposition, and T represents a transposition. The values p and q are constants for determining an evaluation function of the error with respect to the envelope target value, these values being, for example, p=1 and q=1.

Explanation next regards the operation of the adaptive digital filter of the present exemplary embodiment.

The adaptive digital filter of the present exemplary embodiment repeats the processes from adaptive equalizing process S2 to parameter updating process S4 shown in FIG. 4 as in the first exemplary embodiment with each input of a new complex input signal to input terminal 301. However, adaptive equalizing process S2 is a process based on the above-described Equation (16) and parameter updating process S4 is a process based on the above-described Equation (15), Explanation next regards details of the operation of adaptive equalizing process S2 and parameter updating process S4.

First, regarding adaptive equalizing process S2, the complex input signal applied as input to input terminal 301 is supplied to multiplier $346_0$ and complex conjugation unit $340_0$, and at the same time, is supplied to the tapped delay line composed of delay units $330_1$-$330_{N-1}$ for generating delays of one sampling cycle. The complex signal supplied to delay units $330_1$-$330_{N-1}$ is transmitted to an adjacent delay unit with each clock, and the output signals of each of delay units $330_1$-$330_{N-1}$ are supplied to corresponding multipliers $346_1$-$346_{N-1}$ and corresponding complex conjugation units $340_1$-$340_{N-1}$. In addition, the output signal of delay unit $330_{M-1}$ is extracted by branch line 349 and supplied to adder 338.

In multiplier $346_0$, a complex filter coefficient supplied from delay unit $344_0$ is multiplied by the complex signal received as input from input terminal 301 and the result is supplied to adder $337_1$. In multipliers $346_1$-$346_{N-1}$, the complex filter coefficients supplied from corresponding delay units $344_1$-$344_{N-1}$ are multiplied by the complex signals supplied from corresponding delay units $330_1$-$330_{N-1}$ and the results are supplied to adders $337_1$-$337_{N-1}$. Adders $337_1$-$337_{N-1}$ add all complex signals received from multipliers $346_0$-$346_{N-1}$ and supply the results to adder 338.

In adder 338, the signal supplied from adder $337_{N-1}$ is added to the signal extracted by branch line 349, the result is supplied to output terminal 302, and at the same time, supplied to absolute-value circuit 308 and multiplier 181. In this way, the complex signal that is generated by the convolution operation of the complex input signal and a complex filter coefficient and the complex signal extracted from the center tap are added to generate and supply a complex signal.

Next, regarding parameter updating process S4, envelope-target-value generation circuit 305 generates an envelope target value and supplies the value to subtractor 307. On the other hand, absolute-value circuit 308 receives the complex output signal, calculates the absolute value of this value, and transmits the result as the value of the envelope to subtractor 307. Subtractor 307 subtracts the envelope target value received from envelope target value generation unit 305 from the signal received from absolute-value circuit 308 and transmits the result to multiplier 181. multiplier 181 multiplies the complex output signal by the signal received from subtractor 307 and transmits the result to multiplier 182. Step-size generation circuit 303 generates a step size, which is a parameter for determining the amount of filter coefficient updating in the filter unit and supplies this step size to multiplier 182. Multiplier 182 multiplies the step size received from step-size generation circuit 303 by the signal received from multiplier 181 and transmits the result to each of separate units $319_0$-$319_{N-1}$.

In each of separate units $319_0$-$319_{N-1}$, the signal supplied from multiplier 182 is transmitted to multipliers $341_0$-$341_{N-1}$. Complex conjugation units $340_0$-$340_{N-1}$ each subject the complex signal supplied from corresponding delay units $330_1$-$330_{N-1}$ or from input terminal 301 to a complex conjugation conversion and transmit the results to corresponding multipliers $341_0$-$341_{N-1}$. Multipliers $341_0$-$341_{N-1}$ each multiply the complex signals supplied from common unit 318 with the real-number signals supplied from corresponding complex conjugation units $340_0$-$340_{N-1}$ and transmit the results to corresponding adders $343_0$-$343_{N-1}$. Adders $343_0$-$343_{N-1}$ each add the complex filter coefficients supplied from corresponding delay units $344_0$-$344_{N-1}$ to complex signals received from corresponding multipliers $341_0$-$341_{N-1}$ and transmit the results to corresponding delay units $344_0$-$344_{N-1}$ as the filter coefficients for the next sample. Delay units $344_0$-$344_{N-1}$ each delay by one sample the complex filter coefficients received from corresponding adders $343_0$-$343_{N-1}$ and both supply to corresponding multipliers $346_0$-$346_{N-1}$ and transmit to corresponding adders $343_0$-$343_{N-1}$.

Explanation next regards the effect of the present exemplary embodiment.

In the present exemplary embodiment as well, all filter coefficients including the center tap can be limited to a small value, whereby the amount of hardware and the amount of operations of delay units $344_0$-$344_{N-1}$, adders $343_0$-$343_{N-1}$, and multipliers $346_0$-$346_{N-1}$ can be reduced.

In the present exemplary embodiment, the output signal of the filter unit is obtained as a complex number, and the value of the envelope of the output signal, i.e., the amplitude, is therefore obtained instantaneously and accurately as the output signal of absolute-value circuit 308 of FIG. 7. Accordingly, no limitations are placed on the sampling frequency as in the second technique of the related art.

Fourth Exemplary Embodiment

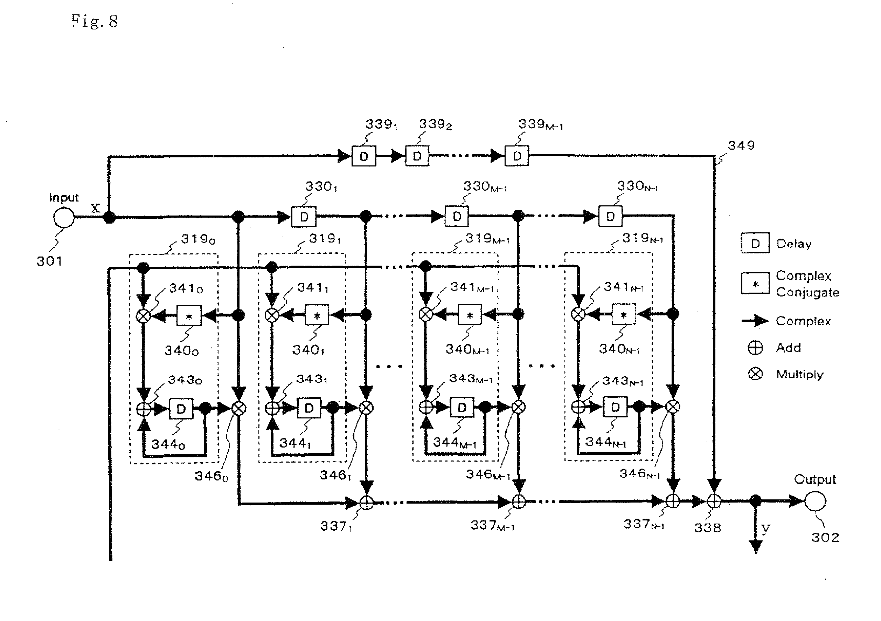

Explanation next regards the adaptive digital filter according to the fourth exemplary embodiment of the present invention using the block diagram of FIG. 8. Common unit 318 of the coefficient control unit shown in FIG. 7 is omitted from the figure.

Referring to FIG. 8, the adaptive digital filter according to the fourth exemplary embodiment of the present invention differs from the adaptive digital filter according to the third exemplary embodiment of FIG. 7 in that the input signal received as input by way of input terminal 301 is transmitted through M-1 delay units $339_1$-$339_{M-1}$ for delaying by (M-1) samples and branch line 349 to adder 338.

The present exemplary embodiment requires an additional M-1 delay units $339_1$-$339_{M-1}$, but the signal that is transmitted to adder 338 by branch line 349 is the same as in the third exemplary embodiment and the same effect as the third exemplary embodiment is therefore obtained.

Fifth Exemplary Embodiment

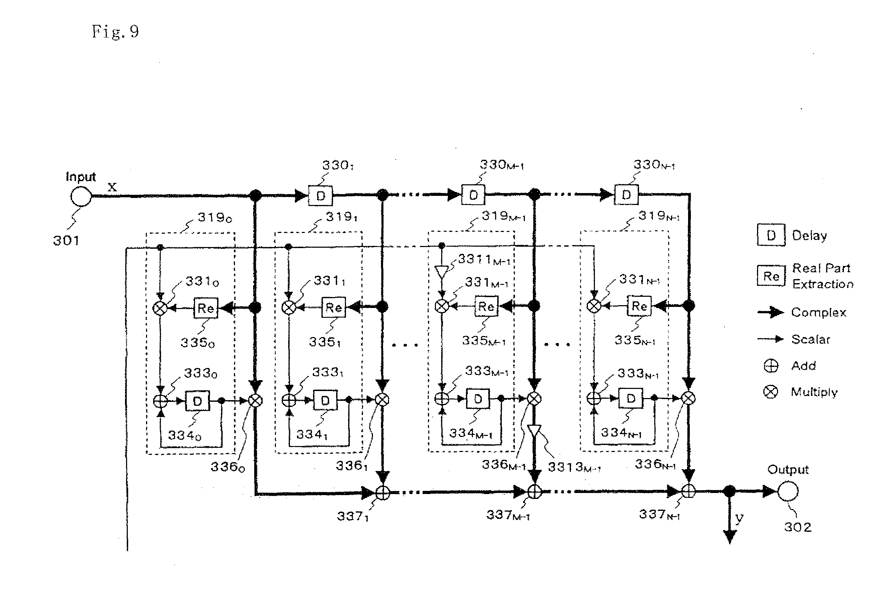

Explanation next regards the adaptive digital filter according to the fifth exemplary embodiment of the present invention using the block diagram of FIG. 9. Common unit 318 of the coefficient control unit shown in FIG. 3 is omitted from the figure.

Referring to FIG. 9, the adaptive digital filter according to the fifth exemplary embodiment of the present invention is provided with multiplier $3311_{M-1}$ in separate unit $319_{M-1}$ for handling the signal of the center tap, and further, is provided with multiplier $3313_{M-1}$ on the output side of multiplier $336_{M-1}$ for multiplying the center tap signal and a filter coefficient in place of branch line 349 and adder 338 in the first exemplary embodiment shown in FIG. 3, and is otherwise the same as the first exemplary embodiment. Multiplier $3311_{M-1}$ reduces the value of the filter coefficient handled by separate unit $319_{M-1}$ by multiplying a prescribed constant C by the signal transmitted in from the common unit. Multiplier $3313_{M-1}$ multiplies the reciprocal of the above-described constant C by the output signal of multiplier $336_{M-1}$ and supplies the result to adder $337_{M-1}$.

The operation of the present exemplary embodiment is next described briefly.

As shown in by the simulation results of FIG. 5, the filter coefficient of the center tap is greater than "1" and the coefficients of other taps are all no greater than 0.5. If it is now assumed that the value of the filter coefficient of the center tap is 1.2, the filter coefficient supplied as output from delay unit $334_{M-1}$ to multiplier $336_{M-1}$ is 1.2 if multiplier $3311_{M-1}$ is absent. However, multiplier $3311_{M-1}$ is present, and if constant C is assumed to be, for example, 0.1, the filter coefficient will be approximately 1/10 of 1.2, or 0.12. Accordingly, if the output signal of delay unit $330_{M-1}$ is X(M-1), the output of multiplier $336_{M-1}$ is 0.12 X(M-1). However, the output of multiplier $336_{M-1}$ is multiplied by the reciprocal of C by multiplier $3313_{M-1}$ of the succeeding stage, and as a result, the signal transmitted to adder $337_{M-1}$ becomes 1.2 X (M-1) and is the same as a case in which multiplier $3311_{M-1}$ and multiplier $3313_{M-1}$ are absent.

Thus, according to the present exemplary embodiment, the equivalent operation is carried out even when the filter coefficient applied to multiplier $336_{M-1}$ of the center tap is made small. As seen in the simulation results of FIG. 5, the values of all filter coefficients other than the center tap are no greater than 0.5, and thus, as a result of the present exemplary embodiment, only values no greater than 0.5 need be handled for all filter coefficients. Accordingly, delay units $334_0$-$334_{N-1}$, adders $333_0$-$333_{N-1}$, and multipliers $336_0$-$336_{N-1}$ need only handle values of 0.5 or less as filter coefficients. The present exemplary embodiment can therefore reduce the amount of operations and the amount of hardware compared to an adaptive digital filter of the related art in which values of 0.5 or more were handled for all filter coefficients.

In the adaptive digital filter of the present exemplary embodiment, the output signal of at least one multiplier of the multipliers for the convolution operations is enlarged, and the signal that depends on the error that serves as the basis for generating the filter coefficient used in this multiplier is reduced to a degree that corresponds to the enlargement, whereby the filter coefficients required in the multipliers for the convolution operations can be made substantially smaller than the related art. As a result, the number of bits required for multipliers for the convolution operation and the delay units for holding the filter coefficients can be decreased, and the amount of operations and amount of hardware can be cut back.

Sixth Exemplary embodiment

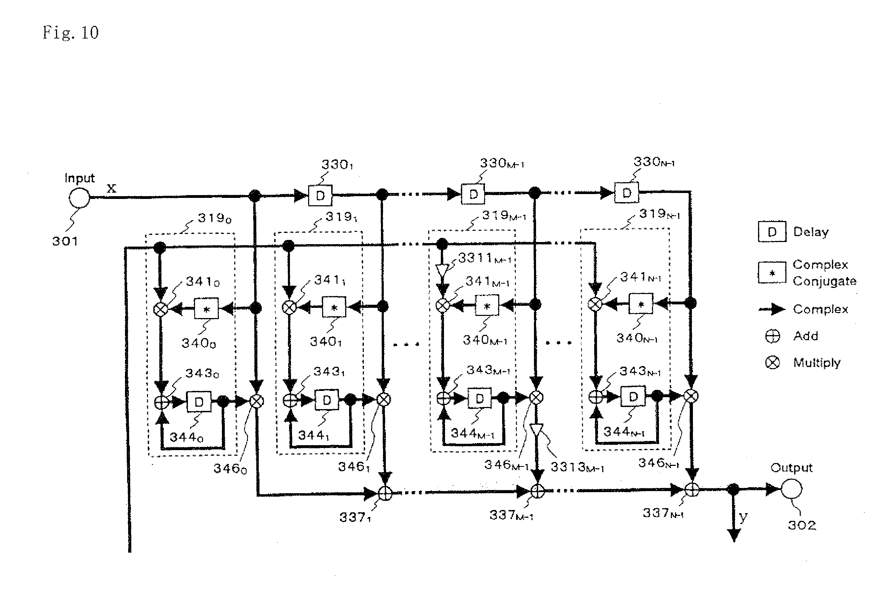

Explanation next regards the adaptive digital filter according to the sixth exemplary embodiment of the present invention using the block diagram of FIG. 10. Common unit 318 of the coefficient control unit shown in FIG. 7 has been omitted from the figure.

Referring to FIG. 10, in place of branch line 349 and adder 338 in the third exemplary embodiment shown in FIG. 7, the adaptive digital filter according to the sixth exemplary embodiment of the present invention is provided with multiplier $3311_{M-1}$ in separate unit $319_{M-1}$ for handling the signal of the center tap, and is further provided with multiplier $3313_{M-1}$ on the output side of multiplier $336_{M-1}$ for multiplying the filter coefficient and the signal of the center tap, but is otherwise the same as the third exemplary embodiment. Multiplier $3311_{M-1}$ reduces the value of the filter coefficient handled in separate unit $319_{M-1}$ by multiplying a prescribed constant C by a signal that is transmitted in from the common unit. Multiplier $3313_{M-1}$ multiplies the reciprocal of the above-described constant C by the output signal of multiplier $336_{M-1}$ and supplies the result as output to adder $337_{M-1}$.

The present exemplary embodiment is a form in which a modification similar to that of the fifth exemplary embodiment is added to the third exemplary embodiment that handles complex filter coefficients and therefore has the effect of enabling a reduction of the amount of operations and the amount of hardware compared to the adaptive digital filter according to the first technique of the related art.

In the above-described first to sixth exemplary embodiments, exemplary embodiments were described that are suitable for cases in which there is one tap in which the filter coefficient becomes greater following convergence, but in cases in which two or more taps are known to exist in which the filter coefficients become greater following convergence, a configuration similar to each of the above-described exemplary embodiments may be added for each of these taps.

For example, when, in addition to the tap that corresponds to the output point of delay unit $330_{M-1}$, the filter coefficient of the tap corresponding to the output point of delay unit $330_{J-1}$ is greater than "1," the output signal of delay unit $330_{J-1}$ in the exemplary embodiments of FIG. 3 and FIG. 7 may be branched by a branch line separate from branch line 349 and transmitted to adder 338, and in adder 338, the signals transmitted from each of the two branch lines may be added to the signal transmitted from adder $337_{N-1}$.

In the exemplary embodiments of FIG. 6 and FIG. 8, the input signal of input terminal 301 may be delayed by $(J-1)$ samples by $(J-1)$ delay units and transmitted to adder 338, and signals transmitted in from each of two branch lines and the signal transmitted from adder $337_{N-1}$ may be added in adder 338.

Still further, in the exemplary embodiments of FIG. 9 and FIG. 10, multipliers similar to multiplier $3311_{M-1}$ and multiplier $3313_{M-1}$ may be provided on the input sides of multipliers $331_{J-1}$ and $341_{J-1}$ and output sides of multipliers $336_{J-1}$ and $346_{J-1}$ of separate unit $319_{J-1}$ for handling an input signal that has been delayed by $(J-1)$ samples.

In addition, filter coefficient groups can be classified in groups according to the expected values of filter coefficients and then processed in group units as in the seventh exemplary embodiment described hereinbelow.

Seventh Exemplary Embodiment

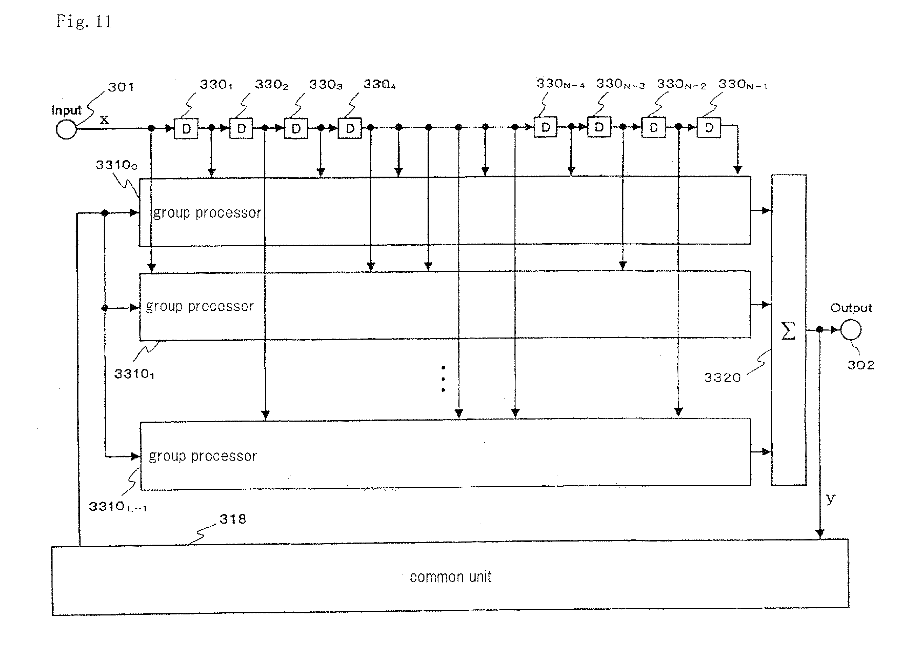

Explanation next regards the adaptive digital filter according to the seventh exemplary embodiment of the present invention using the block diagram of FIG. 11.

Referring to FIG. 11, the adaptive digital filter according to the seventh exemplary embodiment of the present invention is of a configuration that includes: input terminal 301 to which a complex input signal is applied as input; tapped delay line composed of N-1 delay units $330_1$-$330_{N-1}$ for giving a delay of one sampling cycle to the complex input signal that is received by way of input terminal 301 and sequentially transmitting the results; L (where L is a positive integer equal to or greater than 2) group processors $3310_0$-$3310_{L-1}$ corresponding to coefficient groups that are grouped according to the expected values of filter coefficients; adder 3320 for adding the processing results of each of group processors $3310_0$-$3310_{L-1}$ and supplying the result to output terminal 302 as the complex output signal of the adaptive digital filter; and common unit 318 for, upon input of the complex output signal, generating a signal for updating filter coefficients in each of group processors $3310_0$-$3310_{L-1}$ and supplying to each of processors $3310_0$-$3310_{L-1}$. Here, the input signal applied to input terminal 301 and the output signal of each of delay units $330_1$-$330_{N-1}$ are applied as input to only one among processors $331_0$-$3310_{L-1}$.

Common unit 318 is the same as the component in the adaptive digital filter according to the first exemplary embodiment shown in FIG. 3. Group processors $3310_0$-$3310_{L-1}$ are the same as a configuration in which separate units $319_0$-$319_{N-1}$ and filter unit are combined in the adaptive digital filter shown in FIG. 3. Explanation next regards the configuration of group processors $3310_0$-$3310_{L-1}$.

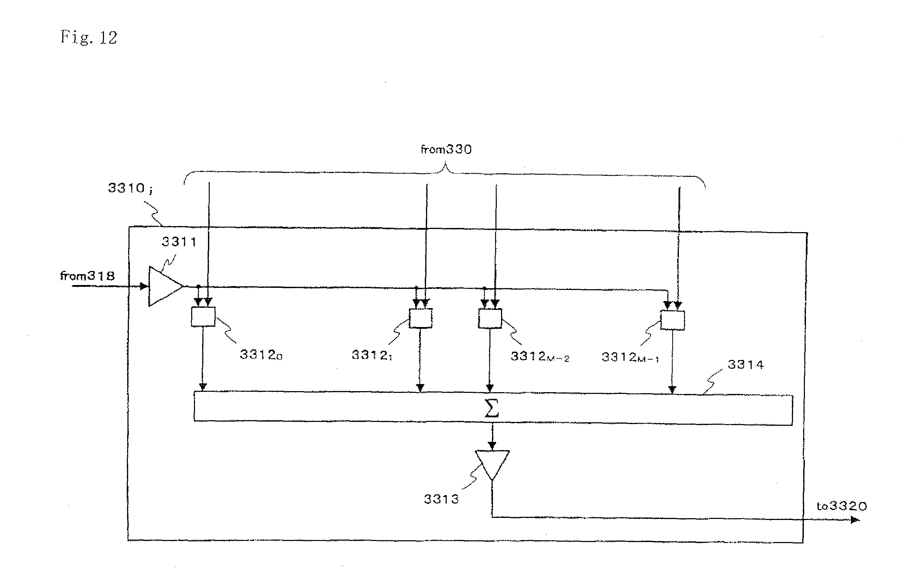

Referring to FIG. 12, each of group processors $3310_j$ (where j = O-N-1) is of a configuration that includes: multiplier 3311 for multiplying a predetermined constant C by the signal received as input from common unit 318 and supplying this result as output; one or more separate processors $3312_0$-$3312_{M-1}$ for receiving as input the output signal of multiplier 3311 and the input signal from input terminal 301 or a signal obtained by delaying the input signal by delay units $330_1$-$330_{N-1}$, i.e., the signal among the signals of each tap that is applied as input to the relevant group processor $3310_j$, carrying out a prescribed operation, and supplying the result as output; adder 3314 for calculating the sum value of the output signals of separate processors $3312_0$-$3312_{M-1}$ and supplying output; and multiplier 3313 for multiplying the reciprocal of the above-described constant C by the output signal of this adder 3314 and transmitting the result to adder 3320 of FIG. 11. Here, constant C is determined as a value appropriate for each group processor, this value that is used being, for example, a value that is inversely proportional to the average value of the expected value of the filter coefficient belonging to that group. In other words, when the average value of the expected value is large, a small value is used; and when the expected value is small, a large value is used.

Explanation next regards the configuration of separate processors $3312_0$-$3312_{M-1}$.

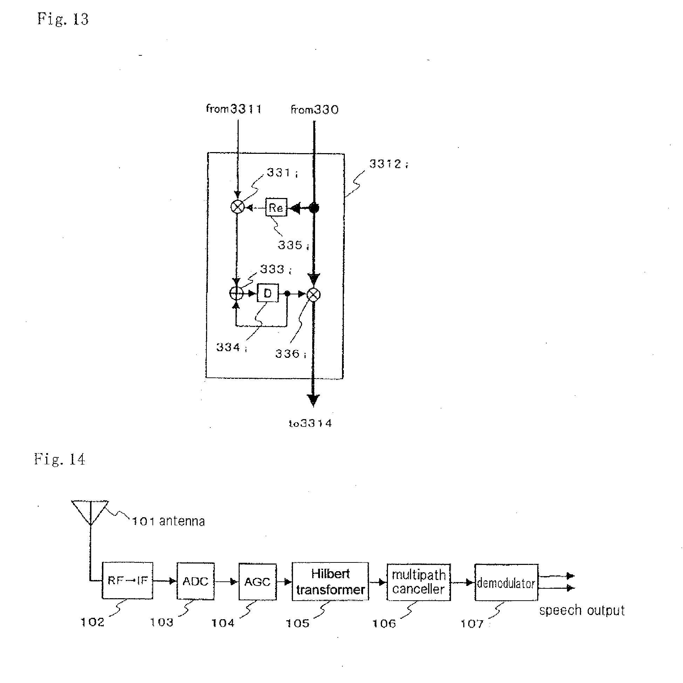

Referring to FIG. 13, each of separate processors $3312_i$ (where i = 0-M-1) is of a configuration that includes: real-part extraction circuit $335_i$ for, upon input of the complex input signal or the output signals of corresponding delay units $330_1$-$330_{N-1}$ on the tapped delay line, extracting only the real parts of the complex signals and supplying the real parts as output; multiplier $331_i$ for multiplying the signal received as input from multiplier 3311 and the real part extracted at real-part extraction circuit $335_i$ and supplying the result; multiplier $336_i$; adder $333_i$ for adding the filter coefficient that is applied to this multiplier $336_i$ and the output of multiplier $331_i$ and supplying the result as the filter coefficient to be used in the next sampling cycle; and delay unit $334_i$ for delaying by one sampling cycle the output of this adder $333_i$ and supplying the result to multiplier $336_i$.

Multiplier $336_i$ multiplies the complex input signal or the output signals of corresponding delay units $330_1$-$330_{N-1}$ on the tapped delay line with the filter coefficient from delay unit $334_i$ and supplies the result to adder 3314 shown in FIG. 12. In other words, in relation to the adaptive digital filter of FIG. 3, one separate processor $3312_i$ corresponds to a configuration in which one multiplier $336_i$ for the above-described convolution operation in a filter unit that carries out convolution operations between an input signal and filter coefficients is combined with one of the plurality of separate units $319_0$-$319_{N-1}$ that make up the coefficient control unit.

Explanation next regards the operation of the present exemplary embodiment. An example is here described in which L=2, i.e., in which filter coefficients are divided into two groups. It is now assumed that the distribution of the values of the filter coefficients of each tap after convergence is divided into the two groups: Group 0 in which filter coefficients belong to the range of at least "1" but less than "1.5" and Group 1 in which filter coefficients belong to the range of less than "0.5." Tapped delay line and group processors $3310_0$ and $3310_1$ are connected in advance such that, of the tap signals, tap signals that belong to Group 0 are applied as input to group processor $3310_0$, and tap signals that belong to Group 1 are applied as input to group processor $3310_1$.

In group processor $3310_0$, constant C that is multiplied by multiplier 3311 of FIG. 12 is set to, for example, "0.1" such that the value of the filter coefficient is reduced as explained in the sixth exemplary embodiment, and the value multiplied by multiplier 3311 is set to the reciprocal of constant C. The amount of operations and the amount of hardware of separate processor $3312_i$ can therefore be reduced for the same reasons as in the sixth exemplary embodiment.

In group processor $3310_1$, on the other hand, the value of the filter coefficients after convergence are 0.5 or less, and constant C can therefore be set to "1" and handled as in the sixth exemplary embodiment. However, if, for example, the values of filter coefficients after convergence are small, the values of the multiplication results of multiplier $331_i$ or multiplier $336_i$ are consequently also small, and fixed-decimal-point operations result in the elimination of the lower-ranked digits and a consequent degradation of the operational accuracy, then multiplication by a constant C that produces larger filter coefficients is also possible. For example, the calculation "$0.1 \cdot 0.2$" results in "0.02," but this result will be "0" if values can be expressed only as far as the first decimal-point digit in a separate processor. If multiplication is here carried out with C = 10, the calculation "$0.1 \cdot 10 = 1.0$" and the multiplication of this result with "0.2" produces "0.2," which can be expressed. The result is here increased by a multiple of 10, but multiplication by the reciprocal of C in multiplier 3313 allows the result to be treated as "0.02" following multiplier 3313.

Although the foregoing explanation regards an example in which filter coefficients are divided into two groups, a case in which the filter coefficients are divided into three or more groups is similar.

The present exemplary embodiment is premised on the exemplary embodiment described in FIG. 3 in which filter coefficients are real numbers, but the present exemplary embodiment can of course also be premised on the exemplary embodiment of FIG. 7 that uses complex filter coefficients.

Using FIG. 14, explanation next regards an FM receiver that uses the adaptive digital filter according to any one of the first to seventh exemplary embodiments.

Referring to FIG. 14, the FM receiver according to the present exemplary embodiment is of a configuration that includes: antenna 101, radio frequency/intermediate frequency converter (RF→IF) 102; analog/digital converter (ADC) 103; automatic gain controller (AGC) 104; Hilbert transformer 105; multipath canceller 106; and demodulator 107. An adaptive digital filter according to any one of the above-described exemplary embodiments is used in this multipath canceller 106.

FM modulated waves received at antenna 101 are converted to a signal of an intermediate frequency band in radio frequency/intermediate frequency converter 102 and transmitted to analog/digital converter 103. Analog/digital converter 103 samples the analog signal transmitted from radio frequency/intermediate frequency converter 102 at an appropriate sampling frequency to convert to a digital signal and transmits the digital signal to automatic gain controller 104. Automatic gain controller 104 multiplies gain such that the amplitude of the output signal falls within a fixed range within a range that does not adversely affect a CMA algorithm that takes the value of the envelope as an index and transmits the result to Hilbert transformer 105.

In Hilbert transformer 105, the signal that has been transmitted from automatic gain controller 104 undergoes conversion to an analytic signal, i.e., a complex signal in which one of two signals having phase shifted 90° with respect to each other is a real part and the other signal is an imaginary part, and the analytic signal is then transmitted to multipath canceller 106. Multipath canceller 106 receives the complex input signal that has been transmitted from Hilbert transformer 105, converts to a signal in which the influence of multiple reflections has been reduced, and transmits the result to demodulator 107. Demodulator 107 subjects the signal transmitted from multipath canceller 106 to FM demodulation and supplies a signal in the speech frequency band. Although a complex output signal is supplied from output terminal 302 of the adaptive digital filter according to each of the above-described exemplary embodiments, only the real part of this complex signal is extracted and supplied to demodulator 107, or only the imaginary part of this complex signal is extracted, the code inverted, and then supplied to demodulator 107.

Although the foregoing explanation regards an exemplary embodiment of the present invention, the present invention is not limited to only the above-described exemplary embodiments and is open to various additions and modifications as described hereinbelow.

In the above-described exemplary embodiments, the envelope target value was taken as a fixed value, but a time-variable envelope target value can also be used that changes based on at least one of the input signal and output signal of the adaptive digital filter.

In exemplary embodiments that employ a branch line, the tap signal that is extracted by means of the branch line is transmitted without change to adder 338, but the tap signal may also be supplied to adder 338 by way of a multiplier that multiplies by a particular coefficient, or the tap signal may be passed through a particular type of filter and supplied to adder 338.

Exemplary embodiments that use real-number filter coefficients employ real-part extraction circuits $335_0$-$335_{N-1}$ and real-part extraction circuit 309, but all or a portion of these components may be replaced by imaginary-part extraction/ inversion circuits. An imaginary-part extraction/inversion circuit is a circuit that extracts only the imaginary part of a complex signal that is received as input and then supplies a value obtained by inverting the code of the imaginary part. A complex input signal that is applied to input terminal 301 of an adaptive digital filter is a complex signal in which one signal of two signals that are generated from one real signal and that have phases shifted 90° with respect to each other is a real part and the other signal is an imaginary part, and using an imaginary-part extraction/inversion circuit therefore obtains the same effect as in the above-described exemplary embodiments.

In exemplary embodiments that employ real-number filter coefficients, all of the filter coefficients are real numbers, i.e., scalar values, but a portion of the filter coefficients can also be made complex numbers, although this approach weakens the effect of reducing the amount of operations. In addition, real-part extraction circuit 309 can be moved to the output side of multiplier 310 or moved to the output side of multiplier 311 and operations carried out by means of complex numbers in multipliers 310 and 311.

Although an FIR filter is used as the filter unit in the above-described exemplary embodiments, an IIR (Infinite Impulse Response) filter can also be used.

Although an LMS algorithm was used as the adaptive algorithm in the above-described exemplary embodiments, various other adaptive algorithms can also be used such as a Recursive Least Squares Algorithm, a Least Squares Algorithm, an Affine Projection Algorithm, and a Gradient Algorithm. If the number of multiplications when updating filter coefficients by means of these adaptive algorithms is more than with the LMS algorithm, the effect of reducing the amount of operations by converting filter coefficients to real numbers is further increased.

Although FM modulation was an object in the above-described exemplary embodiments, the configuration of the present invention can obviously also be applied in other constant-amplitude modulation such as PSK (Phase Shift Keying). If multilevel CMA is used, the present invention can obviously also be applied in modulation modes such as QAM (Quadrature Amplitude Modulation). Still further, among constant modulus algorithms shown in Non-Patent Document 1, the present invention can clearly also be applied in cases in which the output signal is a complex signal.

Although explanation regarded CMA that takes the envelope as index in the above-described exemplary embodiments, the present invention can obviously also be applied in cases in which other statistics that are derived from the output signal are taken as index, as shown in Non-Patent Document 1.

The functions of the adaptive digital filter of the present invention can also be realized by hardware using separate components, ASIC (Application-Specific Integrated Circuits), or FPGA (Field-Programmable Gate Arrays). In addition, the present invention can also be applied to a program for causing the arithmetic processor of a DSP (Digital Signal Processor) that is a computer to execute the signal processing method of the adaptive digital filter of the present invention. This program can be written to a recording medium that can be read by a computer and installed on another computer. The program is provided recorded on a computer-readable recording medium such as a magnetic disk or semiconductor memory, is read by the computer at a time such as the time of start-up of the computer, and by controlling the operations of the computer, causes the computer to function as the adaptive digital filter in each of the above-described exemplary embodiments.

In addition, the present invention is not limited to any of the above-described working examples and is open to various modifications within the scope of the invention, these modifications of course being included within the scope of the present invention.

Potential for Utilization in Industry

As described in the foregoing explanation, the adaptive digital filter according to the present invention is useful as an adaptive digital filter that uses a CMA algorithm, and is particularly suitable for use in the multipath equalizer of an FM receiver.

**Claims**

1. An adaptive digital filter comprising:

   a filter unit that includes a plurality of multipliers divided into groups of at least one multiplier and other multipliers based on expected values of filter coefficients, for generating first signals by means of convolution operations of an input signal and said filter coefficients;
   an adder for adding said input signal that is applied as input to said at least one multiplier and said first signals to supply second signals as output; and
   a coefficient control unit for controlling said filter coefficients based on error between a target signal and an index value derived from said second signals.

2. The adaptive digital filter according to claim 1, wherein, in said at least one multiplier, an initial value set for said expected value of said filter coefficient is greater than in other multipliers.

3. The adaptive digital filter according to claim 1, wherein, in said at least one multiplier, an initial value that is set for said expected value of said filter coefficient is greater than in other multipliers, and only one such multiplier is included in said plurality of multipliers.

4. An adaptive digital filter comprising:

   a filter unit that includes a plurality of multipliers for carrying out convolution operations of an input signal and filter coefficients, for enlarging by a prescribed magnification an output of at least one multiplier of said plurality of multipliers and generating a result of said convolution operation as a first signal; and
   a coefficient control unit for controlling said filter coefficients used in said plurality of multipliers based on error between a target signal and an index value derived from said first signal and for reducing by said magnification a signal that depends on said error that is a basis of generation of said filter coefficients used in said multipliers in which output is enlarged at a prescribed magnification.

5. The adaptive digital filter according to claim 4, wherein said filter coefficients are divided into a plurality of groups based on expected values of filter coefficients, and said magnification when enlarging or said magnification when reducing is set for each of said groups.

6. The adaptive digital filter according to any one of claims 1 to 5, wherein:

   said input signal is a complex signal in which one of two signals that are generated from a single real signal and that have phases shifted 90° with respect to each other is a real part and the other signal is an imaginary part; and
   said filter coefficients are real signals.

7. The adaptive digital filter according to claim 6, wherein said coefficient control unit includes:

   a common unit for generating and supplying as output a real signal that accords with error between said index value and said target signal; and
   a plurality of separate units provided for each of said plurality of multipliers for convolution operations in said filter unit, for calculating real filter coefficients that are to be used in the next sampling cycle based on: a signal in which a complex signal that is applied as input to a corresponding multiplier has been converted to a real number, said real signal that is applied as input from said common unit, and a current real filter coefficient.

8. The adaptive digital filter according to any one of claims 1 to 5, wherein said coefficient control unit takes a value of an envelope of said first signal as said index value.

9. An FM receiver comprising:

   an adaptive digital filter according to any one of claims 1 to 5; and
   a Hilbert transformer for applying as input to said adaptive digital filter a complex signal that has been generated by subjecting an FM modulated signal that has been converted to an intermediate frequency and digitized to Hilbert transformation.

**10.** A signal processing method of an adaptive digital filter having:

a filter unit that includes a plurality of multipliers, and a coefficient control unit for controlling filter coefficients of said plurality of multipliers; said signal processing method comprising steps wherein:

said plurality of multipliers are divided into groups of at least one multiplier and the other multipliers based on expected values of filter coefficients, and an adder is provided for adding a signal that is applied as input to said at least one multiplier to a first signal that is an output of said filter unit;

said filter unit generates said first signals by means of convolution operations of an input signal and said filter coefficients;

said adder adds said input signal that is applied as input to said at least one multiplier and said first signal to supply second signals; and

said coefficient control unit controls said filter coefficients based on error between a target signal and an index value derived from said second signals.

**11.** The signal processing method according to claim 10, wherein an initial value that is set for said expected value of said filter coefficient of said at least one multiplier is greater than in other multipliers.

**12.** The signal processing method according to claim 10, wherein an initial value set for said expected value of said filter coefficient in said at least one multiplier is greater than in other multipliers, and only one such multiplier is included in said plurality of multipliers.

**13.** A signal processing method of an adaptive digital filter that includes: a filter unit that includes a plurality of multipliers, and a coefficient control unit for controlling filter coefficients of said plurality of multipliers; said signal processing method comprising steps wherein:

said filter unit carries out convolution operations of an input signal and filter coefficients, enlarges at a prescribed magnification an output of at least one multiplier among said plurality of multipliers, and generates a result of said convolution operations as first signals; and

said coefficient control unit controls said filter coefficients that are used in said plurality of multipliers based on error between a target signal and an index value derived from said first signals, and reduces by said prescribed magnification a signal that depends on said error that is a basis of generating said filter coefficients that are used in said multipliers in which output is enlarged at said prescribed magnification.

**14.** The signal processing method according to claim 13, wherein:

said filter coefficients are divided into a plurality of groups based on expected values of filter coefficients; and said magnification when enlarging or said magnification when reducing is set for each of said groups.

**15.** The signal processing method according to any one of claims 10 to 14, wherein:

said input signal is a complex signal in which one of two signals that is generated from one real signal and that have phases shifted 90° with respect to each other is a real part and the other signal is an imaginary part; and said filter coefficients are real signals.

**16.** The signal processing method according to claim 15, wherein:

said coefficient control unit generates real signals according to error between said index value and said target signal; and

said coefficient control unit calculates real filter coefficients that are to be used in the next sampling cycle for each of said plurality of multipliers based on: a signal in which a complex signal that is applied as input to a corresponding multiplier is converted to a real number, said real signal that is applied as input from said common unit, and a current real filter coefficient.

**17.** The signal processing method according to any one of claims 10 to 14, wherein said coefficient control unit takes a value of an envelope of said first signals as said index value.

**18.** A program for causing a computer to execute operations of an adaptive digital filter that includes: a filter unit that includes a plurality of multipliers, and a coefficient control unit for controlling filter coefficients of said plurality of multipliers; said program causing said computer to execute processes wherein:

said plurality of multipliers are divided into groups of at least one multiplier and the other multipliers based on expected values of filter coefficients, and an adder is provided for adding a signal that is applied as input to said at least one multiplier to first signals that are outputs of said filter unit;
said filter unit generates said first signals by means of convolution operations of an input signal and said filter coefficients;
said adder adds said input signal that is applied as input to said at least one multiplier and said first signals and supplies second signals; and
said coefficient control unit controls said filter coefficients based on error between a target signal and an index value derived from said second signals.

19. The program according to claim 18, wherein an initial value that is set for said expected value of said filter coefficient of said at least one multiplier is greater than for other multipliers.

20. The program according to claim 18, wherein an initial value set for said expected value of said filter coefficient of said at least one multiplier is greater than for other multipliers, and only one such multiplier is included in said plurality of multipliers.

21. A program for causing a computer to execute operations of an adaptive digital filter that includes: a filter unit that includes a plurality of multipliers, and a coefficient control unit for controlling filter coefficients of said plurality of multipliers; wherein said program causes said computer to execute processes wherein:

said filter unit carries out convolution operations of an input signal and filter coefficients, enlarges at a prescribed magnification an output of at least one multiplier among said plurality of multipliers, and generates a result of said convolution operations as first signals; and
said coefficient control unit controls said filter coefficients that are used in said plurality of multipliers based on error between a target signal and an index value derived from said first signals, and reduces by said prescribed magnification a signal that depends on said error that serves as a basis of generation of said filter coefficients that are used in said multipliers in which outputs are enlarged at said prescribed magnification.

22. The program according to claim 21, further comprising a process wherein:

said filter coefficients are divided into groups based on expected values of filter coefficients; and
said magnification when enlarging or said magnification when reducing is set for each of said groups.

23. The program according to any one of claims 18 to 22, wherein:

said input signal is a complex signal in which one of two signals that are generated from one real signal and that have phases shifted 90° with respect to each other is a real part and the other signal is an imaginary part; and
said filter coefficients are real signals.

24. The program according to claim 23, wherein:

said coefficient control unit generates real signals according to error between said index value and said target signal; and
said coefficient control unit calculates real filter coefficients to be used in a next sampling cycle for each of said plurality of multipliers based on: a signal in which a complex signal applied as input to a corresponding multiplier is converted to a real number, said real signal that is applied as input from said common unit, and a current real filter coefficient.

25. The program according to any one of claims 18 to 22, wherein said coefficient control unit takes a value of an envelope of said first signals as said index value.

Fig. 1

EP 1 906 530 A1

Fig. 2

Fig. 3

Fig. 4

```
┌──────────────────────────────────┐
│                                  │
│         ↓                        │
│   ┌──────────────┐  ⌇ S1         │
│   │ input process│               │
│   └──────────────┘               │
│         ↓                        │
│   ┌──────────────┐  ⌇ S2         │
│   │ adaptive     │               │
│   │ equalizing process│          │
│   └──────────────┘               │
│         ↓                        │
│   ┌──────────────┐  ⌇ S3         │
│   │ output process│              │
│   └──────────────┘               │
│         ↓                        │
│   ┌──────────────┐  ⌇ S4         │
│   │ parameter    │               │
│   │ update process│              │
│   └──────────────┘               │
│         │                        │
└─────────┘                        
```

EP 1 906 530 A1

Fig. 5

24

Fig. 6

Fig. 7

Fig. 8

Fig.9

EP 1 906 530 A1

Fig. 10

Fig.11

Fig. 12

Fig. 13

from3311    from330

331 ;            3312 ;

⊗ ←— Re ←——●

335 ;

333 ;

⊕ —→ D —→●—→ ⊗

334 ;        336 ;

to3314

Fig. 14

101 antenna

RF→IF →  ADC →  AGC →  Hilbert transformer →  multipath canceller →  demodulator →

102      103     104      105                  106                 107

speech output

## INTERNATIONAL SEARCH REPORT

| International application No. |
|---|
| PCT/JP2006/314153 |

A. CLASSIFICATION OF SUBJECT MATTER
*H03H21/00*(2006.01)i, *H03H17/02*(2006.01)i, *H03H17/06*(2006.01)i, *H04B3/06*
(2006.01)i, *H04B7/005*(2006.01)i

According to International Patent Classification (IPC) or to both national classification and IPC

B. FIELDS SEARCHED

Minimum documentation searched (classification system followed by classification symbols)
H03H17/00-21/00, H04B3/04-3/18, H04B7/005

Documentation searched other than minimum documentation to the extent that such documents are included in the fields searched
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2005-167717 A (Pioneer Electronic Corp.), 23 June, 2005 (23.06.05), Full text; all drawings & US 2005-0123035 A1 & EP 1542415 A2 | 1-25 |
| A | JP 2005-064618 A (Pioneer Electronic Corp.), 10 March, 2005 (10.03.05), Full text; all drawings & US 2005-0053177 A1 & EP 1508968 A2 | 1-25 |
| A | JOHN R.TREICHLER AND BRAIN G.AGEE, A NEW Approach to Multipath Correction of Constant Modulus Signals", IEEE TRANSACTIONS ON ACOUSTICS, SPEECH, AND SIGNAL PROCESSING, VOL.ASSP-31, NO.2, 1983 | 1-25 |

☒ Further documents are listed in the continuation of Box C. ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 17 October, 2006 (17.10.06) | 31 October, 2006 (31.10.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.

PCT/JP2006/314153

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2003-168957 A  (Sharp Corp.),<br>13 June, 2003 (13.06.03),<br>Full text; all drawings<br>(Family: none) | 1-25 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005064618 A

**Non-patent literature cited in the description**

- **C. RICHARD JOHNSON, JR. ; PHILIP SCHNITER ; THOMAS J. ENDRES ; JAMES D. BEHM ; DONALD R. BROWN ; RAÚL A. CASAS.** Blind Equalization Using the Constant Modulus Criterion: A Review. *Proceedings of IEEE,* October 1998, vol. 86 (10

- **J. R. TREICHLER ; B. G. AGEE.** A New Approach to Multipath Correction of Constant Modulus Signals. *IEEE Transactions on Acoustics, Speech, and Signal Processing,* April 1983, vol. 31 (2), 459-472
- **ITAMI MAKOTO ; HATORI MITSUTOSHI ; TSUKAMOTO NORIO.** Hardware Implementation of FM Multipath Distortion Canceller. *National Convention Record of the Institute of Television Engineers of Japan,* 1986, 355-356